# EUROPEAN PATENT APPLICATION

(11) **EP 1 329 895 A2**
(43) Date of publication of application: **23.07.2003**
(21) Application number: 02256805.9
(22) Date of filing: 30.09.2002
(51) Int. Cl.: G11C 11/16

(54) **High-density magnetic random access memory device and method of operating the same**

(30) Priority: 08.01.2002 KR 2002000988
(71) Applicant: SAMSUNG ELECTRONICS Co. Ltd., Kyungki-do, Seoul (KR)
(72) Inventor: Kim, Tae-wan 4-808 Samho Apt., Anyang-city Kyunki-do (KR); Park, Sang-jin, Pyeongtaek-city, Kyungki-do (KR); Park, Wan-jun, Gangnam-gu, Seoul (KR); Song, I-hun, Bundang-gu, Seongnam-city, Kyungki-do (KR)
(74) Representative: Greene, Simon Kenneth

(57) **Abstract**

A high-density magnetic memory device is provided. The high-density magnetic memory device includes a vertical transistor formed on a substrate; a magnetic memory element formed on the vertical transistor, the magnetic memory element using magnetic materials for storing data; a bit line connected to the transistor via the magnetic memory element; a word line for writing over and across the bit line; and an insulating layer formed between the word line for writing, and the other components below the word line for writing. According to the high-density magnetic memory device, it is possible to fabricate a high-density magnetic memory device with a vertical transistor.

## Description

The present invention relates to a high-density magnetic random access memory device and a method of operating the same, and more particularly, to a high-density magnetic random access memory device having a vertical transistor, and a method of operating the same.

A magnetic random access memory (MRAM) device is a kind of non-volatile memory devices, and stores data using the magnetic characteristics of a material. The MRAM device can perform speedy read/write operations of a static random access memory (SRAM), has a high degree of integration equivalent to that of a dynamic random access memory (DRAM), and theoretically, it can perform write operations repeatedly if required.

The MRAM device includes a magnetic memory element required in writing and reading data. Here, the magnetic memory element may be a giant magneto-resistive (GMR) device using a GMR phenomenon, or a magnetic tunnel junction (MTJ) device using a phenomenon that an electric current is more easily transmitted when two magnetic layers, which has an insulating layer therebetween, have the same magnetic spin direction, than when these magnetic layers have the different magnetic spin direction. At present, the MTJ device is widely used because it has higher junction resistance and magneto-resistive (MR) ratio than the GMR device.

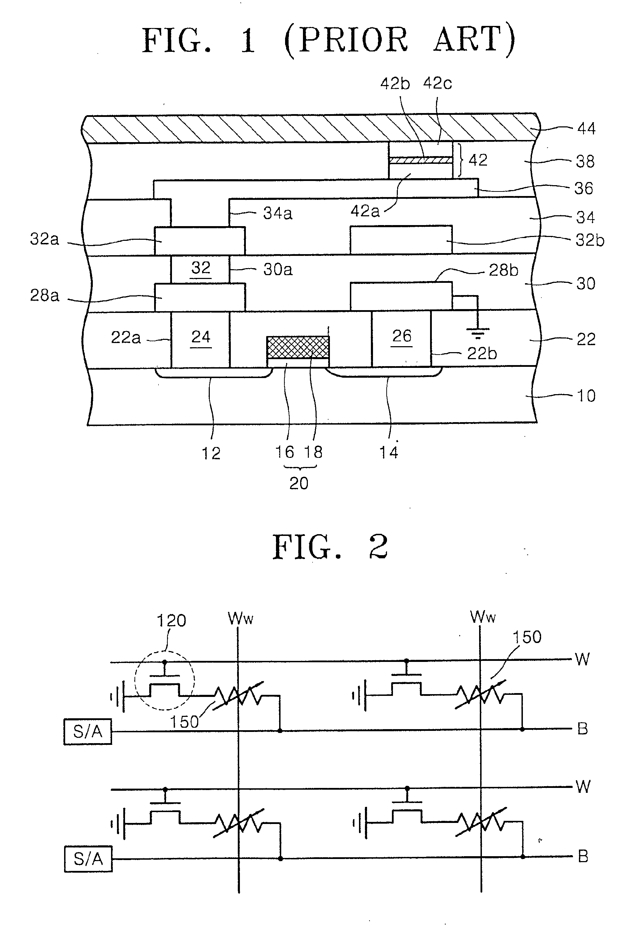

FIG. 1 is a cross-sectional view of a conventional MRAM device. Referring to FIG. 1, first and second impurity layers 12 and 14, which are doped with n-type conductive impurities, are formed in a p-type semiconductor substrate 10 at an interval therebetween. A gate stack 20, which consists of a gate oxide layer 16 and a gate conductive layer 18, is formed on the p-type semiconductor substrate 10 between the first and second impurity layers 12 and 14. Here, the gate conductive layer 18 is also used as a word line for reading. As a result, a metal-oxide semiconductor field effect transistor (MOSFET) is formed on the p-type semiconductor substrate 10. Then, a first interlayer dielectric layer 22 is formed to cover the gate stack 20 on the p-type semiconductor substrate 10. First and second via holes 22a and 22b are formed at the first interlayer dielectric layer 22 to expose portions of the first and second impurity layers 12 and 14. The first and second via holes 22a and 22b are filled with conductive plugs 24 and 26. Then, first and second conductive layer patterns 28a and 28b are formed on the first interlayer dielectric layer 22 at an interval to completely cover the exposed portions of the conductive plugs 24 and 26, respectively. Next, a second interlayer dielectric layer 30 is formed to cover the first and second conductive layer patterns 28a and 28b. Here, the second conductive layer pattern 28b is used as a ground line. Thereafter, a third via hole 30a is formed on the second interlayer dielectric layer 30 to expose the first conductive layer pattern 28a, and then filled with a conductive plug 32.
Next, third and fourth conductive layer patterns 32a and 32b are formed on the second interlayer dielectric layer 30 at an interval. At this time, the third conductive layer pattern 32a covers the exposed portion of the conductive plug 32 completely. Here, the fourth conductive layer pattern 32b is a word line for writing. Then, a fourth via hole 34a is formed on the third interlayer dielectric layer 34 to expose the third conductive layer pattern 32a. Next, a fifth conductive layer pattern 36 is formed on the third interlayer dielectric layer 34 to fill the fourth via hole 34a while being extended over the fourth conductive layer pattern 32b. A tunneling magnetic resistive (TMR) device 42 is formed on the fifth conductive layer pattern 36. The TMR device 42 is a stacked structure in which a first ferromagnetic layer 42a, a non-ferromagnetic layer 42b and a second ferromagnetic layer 42c are sequentially stacked. Then, a fourth interlayer dielectric layer 38 is formed on the third interlayer dielectric layer 34 to cover the fifth conductive layer pattern 36 and the both sides of the TMR device 42. Lastly, a bit line 44 is formed on the fourth interlayer dielectric layer 38 to be in contact with the entire surface of the second ferromagnetic layer 42c.

In a conventional MRAM device as shown in FIG. 1, a switching device is selected to choose one cell, and therefore, an area occupied by the chosen cell depends on the area of the selected switching device. It is important to reduce the area of a switching device as much as possible in fabricating a high-density magnetic memory device.

According to a first aspect of the invention there is provided a high-density magnetic memory device including a vertical transistor formed on a substrate; a magnetic memory element formed on the vertical transistor, the magnetic memory element using magnetic materials for storing data; a bit line connected to the transistor via the magnetic memory element; a word line for writing over and across the bit line; and an insulating layer formed between the word line for writing, and the other components below the word line for writing.

Thus, there is provided a high-density magnetic memory device in which a transistor is arranged in the vertical direction so that an area occupied by a switching device can be reduced, thereby increasing the degree of integration.

According to a second aspect of the invention, there is provided a method of operating a high-density magnetic device according to the present invention, the method including: (a) applying an electric current to the bit line to address one memory cell, applying an electric current *Iw* to the word line for writing so that the magnetization directions of the magnetic layers of the MTJ are anti-parallel to each other, and writing "1" to the selected memory cell; (b) applying an electric current to the bit line to address one memory cell, applying an electric current *-Iw* whose direction is opposite to that of the electric current *Iw,* to the word line for writing so that the magnetization directions of these magnetic layers are parallel to each other, and writing "0" to the selected memory cell; and (c) selecting a memory cell by applying predetermined voltage to the bit line and the word line, detecting the intensity of an electric current of the bit line, and reading data written to the memory cell.

The features and advantages of the present invention will become more apparent by describing in detail a preferred embodiment thereof with reference to the attached drawings in which:
FIG. 1 is a cross-sectional view of a conventional magnetic random access memory (MRAM) device;
FIG. 2 is an equivalent diagram of a cell array of a high-density magnetic memory device according to a preferred embodiment of the present invention;
FIG. 3 is a cross-sectional view of a high-density magnetic memory device according to a preferred embodiment of the present invention; and
FIGS. 4A through 4C are views explaining a method of operating a high-density magnetic memory device according to a preferred embodiment of the present invention.

The present invention will now be described more fully with reference to the accompanying drawings, in which a preferred embodiment is shown. This invention may, however, be embodied in many different forms and should not be construed as being limited to the embodiment set forth herein; rather, this embodiment is provided so that this disclosure will be thorough and complete, and will fully convey the concept of the invention to those skilled in the art. In the drawings, the thickness of layers and regions are exaggerated for clarity.

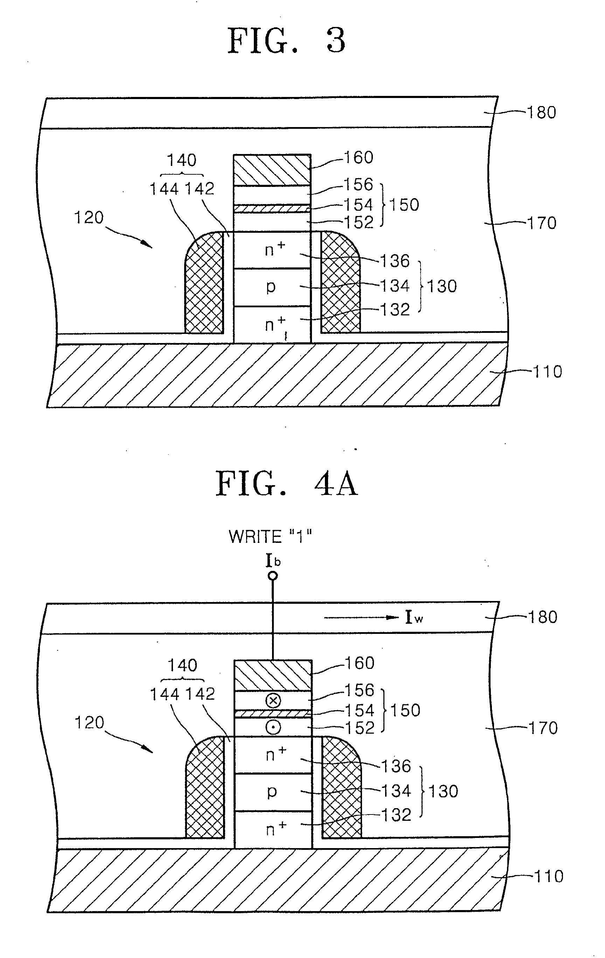

FIG. 2 is an equivalent diagram of a cell array of a high-density magnetic memory device according to a preferred embodiment of the present invention. Here, reference numeral 120 denotes a memory transistor, and reference numeral 150 denotes a magnetic memory element having a variable resistance, which is to be described later. *B* indicates a bit line, and *W* indicates a word line connected to the gate of a transistor. Also, *Ww* is a word line for writing, which is placed across the magnetic memory element 150 and is isolated from other lines.

A plurality of transistors 120 are arranged lengthwise and crosswise in a cell array. The cell array includes the word lines *W*, the word lines *Ww* for writing, and the bit lines *B* that are equivalent in number to the crosswise arranged lines of sthe transistors 120. Here, each bit line *B* is connected to means for measuring an electric current. Preferably, the means for measuring an electric current is a sense amplifier (S/A). Each bit line *B* may, however, be connected to another current measuring apparatus.

FIG. 3 is a cross-sectional view of a high-density magnetic memory device according to a preferred embodiment of the present invention. Referring to FIG. 3, a vertical transistor 120 and a magnetic memory element 150 are sequentially formed on a substrate 110. The vertical transistor 120 consists of an impurity stack 130 in which a first impurity layer 132, a channel layer 134 and a second impurity layer 136 are sequentially stacked, and a gate stack 140 covering the both sides of the impurity structure 130.

Here, the first and second impurity layers 132 and 136 are doped with n+ type conductive impurities, and the channel layer 134 is doped with p type conductive impurities.

Each gate stack 140 consists of a gate insulating layer 142 and a gate conductive layer 144. More specifically, the gate insulating layer 142 and the gate conductive layer 144 are sequentially stacked along each side of the impurity stack 130 to form the gate stack 140. The gate conductive layer 144 is a layer having high conductivity, and may be a polycide or metal layer, for example.

The magnetic memory element 150 for storing data is formed on the impurity stack 130. Here, the magnetic memory element 150 is a magnetic tunnel junction (MTJ) device having at least two magnetic layers 152 and 156, and a tunnel barrier 154. Here, the tunnel barrier 154 is interposed between the magnetic layers 152 and 156. In this embodiment, the magnetization direction of the lower magnetic layer 152 beneath the tunnel barrier 154 is fixed, whereas the magnetized direction of the upper magnetic layer 156 above the tunnel barrier 154 becomes parallel or anti-parallel to that of the upper magnetic layer 156 according to the electric field.

A bit line 160 is formed on the magnetic memory element 150, being extended in the same direction as a word line of the gate conductive layer 144. Above the bit line 160, a word line for writing 180 is formed across the word line of the gate conductive layer 144 and the bit line 160. The word line for writing 180 stores data at the magnetic memory element 150 by forming a magnetic field in a predetermined direction. Also, an insulating layer 170 is applied between the word line for writing 180, and the other components below the word line for writing 180.

Hereinafter, a method of operating the magnetic memory device according to the present invention will be described with reference to FIGS. 4A through 4C.

### Writing Operation

First, an electric current *Ib* is applied to the bit line 160 so as to address the position of a memory cell to which data is to be written. Next, an electric current *Iw* in one direction is applied to the word line for writing 180 so that the directions of the magnetization of the magnetic layers 152 and 156 of the MTJ 150 are anti-parallel to each other, and then, "1" is written to a selected memory cell. In other words, as shown in FIG. 4A, the magnetization direction of the upper magnetic layer 156 is determined by a magnetic field, which is formed by the electric current *Iw,* and is opposite to the magnetization direction of lower magnetic layer 152.

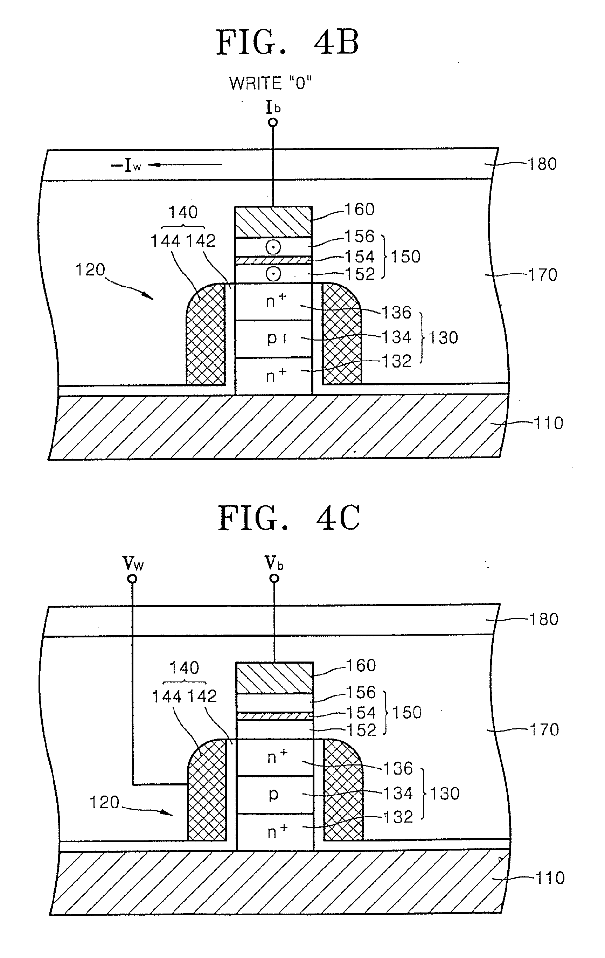

To write "0" to the selected memory cell, the electric current *Ib* is applied to the bit line 160, and an electric current *-Iw* whose direction is opposite to that of the electric current *Iw,* which is applied to write "1" to the word line for writing 180, is applied to the word line for writing 180. As a result, as shown in FIG. 4B, the magnetization direction of the upper magnetic layer 156 is also determined by a magnetic field, which is formed by the electric current *-Iw,* which is applied to the word line for writing 180. At this time, the magnetization direction of the upper magnetic layer 156 is parallel to that of the lower magnetic layer 152.

### Reading Operation

First, one memory cell is addressed by applying voltages *Vb* and *Vw to* the bit line 160 and the word line 144. Then, data written to the selected memory cell is read by detecting the intensity of an electric current with the sense amplifier S/A connected to the bit line 160. While the same voltage is applied to the bit line 160 and the word line 144, the resistance of the MTJ 150 is relatively low if a relatively high electric current is detected. At this time, the magnetization directions of the magnetic layers 152 and 156 of the MTJ 150 are parallel to each other, and "0" is written to a selected memory cell. On the contrary, while the same voltage is applied to the bit line 160 and the word line 144, the resistance of the MTJ 150 is relatively high if a relatively low electric current is detected. In this case, the magnetization directions of the magnetic layers 152 and 156 are anti-parallel to each other, and "1" is written to a selected memory cell.

In this embodiment, "1" is written or read to or from a memory cell when the magnetization directions of magnetic layers of a magnetic memory element are anti-parallel to each other, whereas "0" is written or read when the magnetization directions of these magnetic layers are parallel to each other. However, it is possible to switch the conditions of reading/writing "1" and "0".

As describe above, according to the present invention, it is possible to fabricate a high-density magnetic memory device with a vertical transistor.

## Claims

1. A magnetic memory device comprising:
a vertical transistor formed on a substrate;
a magnetic memory element formed on the vertical transistor, the magnetic memory element using magnetic materials for storing data;
a bit line connected to the transistor via the magnetic memory element;
a word line for writing over and across the bit line; and
an insulating layer formed between the word line for writing, and the other components below the word line for writing.

2. The magnetic memory device of claim 1, wherein the vertical transistor comprises:
an impurity stack in which a first impurity layer, a channel layer and a second impurity layer are sequentially stacked; and
a gate stack for covering the both sides of the impurity stack.

3. The magnetic memory device of claim 2, wherein the gate stack comprises a gate insulating layer and a gate conductive layer that are sequentially formed from the both sides of the impurity stack.

4. The magnetic memory device of any preceding claim, wherein the magnetic memory element is a magnetic tunnel junction MTJ.

5. A method of operating a high-density magnetic memory device as claimed in claim 1, the method comprising:
(a) applying an electric current to the bit line to address one memory cell, applying an electric current *Iw* to the word line for writing so that the magnetization directions of the magnetic layers of the MTJ are anti-parallel to each other, and writing "1" to the selected memory cell;
(b) applying an electric current to the bit line to address one memory cell, applying an electric current *-Iw* whose direction is opposite to that of the electric current *Iw,* to the word line for writing so that the magnetization directions of these magnetic layers are parallel to each other, and writing "0" to the selected memory cell; and
(c) selecting a memory cell by applying predetermined voltage to the bit line and the word line, detecting the intensity of an electric current of the bit line, and reading data written to the memory cell.

6. The method of claim 5, wherein (c) is performed by detecting the electric current of the bit line via a sense amplifier connected to the bit line.
